# EUROPEAN PATENT APPLICATION

(11) **EP 4 040 498 A1**
(43) Date of publication of application: **10.08.2022**
(21) Application number: 22154844.9
(22) Date of filing: 02.02.2022
(51) Int. Cl.: H01L 29/06, H01L 29/16, H01L 29/36, H01L 29/66, H01L 29/872

(54) **VERTICAL CONDUCTION ELECTRONIC DEVICE COMPRISING A JBS DIODE AND MANUFACTURING PROCESS THEREOF**

(30) Priority: 03.02.2021 IT 202100002336
(71) Applicant: STMicroelectronics S.r.l., 20864 Agrate Brianza (MB) (IT)
(72) Inventor: RASCUNA', Simone, 95129 CATANIA (IT); BELLOCCHI, Gabriele, 95124 CATANIA (IT); ZANETTI, Edoardo, 95028 VALVERDE (IT); SAGGIO, Mario Giuseppe, 95020 ACI BONACCORSI (IT)
(74) Representative: Studio Torta S.p.A.

(57) **Abstract**

The vertical conduction electronic device (50) is formed by a body (55) of wide-bandgap semiconductor material having a first conductivity type and a surface (55A), which defines a first direction (Y) and a second direction (X), wherein the body has a drift region (59, 59A, 59B). The electronic device is further formed by a plurality of superficial implanted regions (62) having a second conductivity type, which extend in the drift region from the surface and delimit between them, in the drift region, at least one superficial portion (68) facing the surface; by at least one deep implanted region (65) having the second conductivity type, which extends in the drift region, at a distance from the surface of the body; and by a metal region (80), which extends on the surface of the body, in Schottky contact with the superficial portion (68) of the drift region.

## Description

The present invention relates to a vertical conduction electronic device comprising a JBS (Junction Barrier Schottky) diode and to the manufacturing process thereof. In particular, reference will be made hereinafter to a wide-bandgap semiconductor electronic device.

As is known, semiconductor materials having a wide bandgap, for example greater than 1.1 eV, low on-state resistance, high thermal conductivity, high operating frequency, and high velocity of saturation of the charge carriers, such as silicon carbide (SiC) and gallium nitride (GaN), allow to obtain electronic devices, for example diodes and transistors, having improved performance as compared to silicon electronic devices, in particular for power applications, for example operating at voltages comprised between 600 V and 1300 V or in specific operating conditions, such as high temperature.

In particular, it is known to obtain such electronic devices from a wafer of silicon carbide in one of its polytypes, for example 3C-SiC, 4H-SiC and 6H-SiC, which are distinguished by the characteristics listed above.

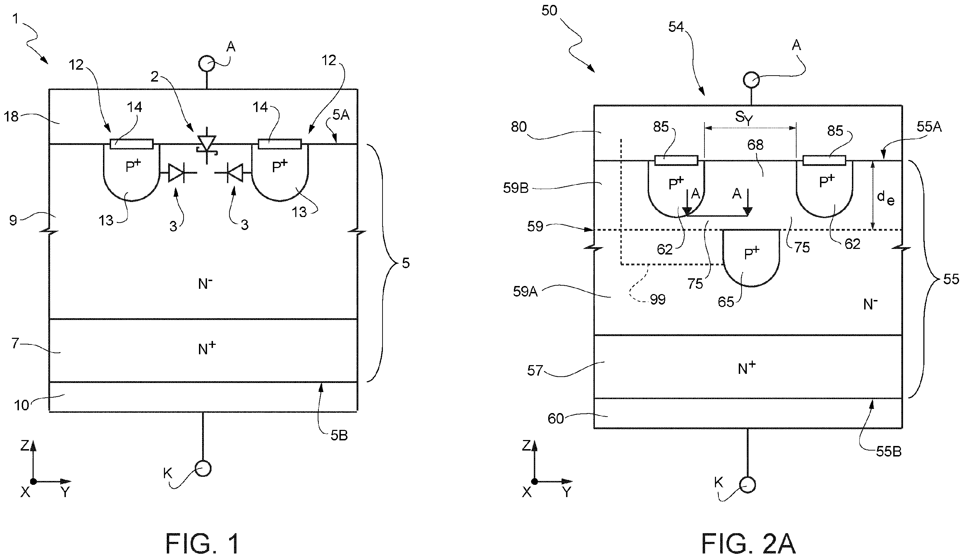

For instance, Figure 1 shows a known JBS diode 1, of silicon carbide, in a Cartesian reference system XYZ comprising a first axis X, a second axis Y and a third axis Z.

The JBS diode 1 is generally formed by a plurality of elementary cells (only one is shown), which are equal to one another and are arranged in parallel in a same die; each elementary cell comprises a Schottky diode 2 and a pair of PN diodes 3, mutually connected in parallel.

The JBS diode 1 is formed in a body 5 of silicon carbide (SiC), which is delimited by a first surface 5A and a second surface 5B and comprises a substrate 7 and a drift region 9 overlying the substrate 7, for example grown epitaxially thereon.

The substrate 7 is of an N type and forms the second surface 5B of the body 5.

The drift region 9 is of an N type, with a doping level lower than the doping level of the substrate 7, and forms the first surface 5A of the body 5.

A cathode metallization region 10 of conductive material, for example nickel or nickel silicide, extends on the second surface 5B of the body 5 and forms a cathode K of the JBS diode 1.

The JBS diode 1 further comprises a plurality of barrier regions 12, of which two barrier regions 12 are visible in Figure 1, substantially accommodated in the drift region 9.

The barrier regions 12 are mutually spaced apart along the second axis Y and are each formed by a respective implanted region 13 of a P type, which extends from the first surface 5A of the body 5 into the drift region 9. The barrier regions 12 moreover extend along the first axis X, for example strip-shaped.

The barrier regions 12 each further comprise a respective ohmic-contact region 14, of conductive material, for example nickel silicide, which extends on a respective implanted region 13, partially inside it, and, in the cross-sectional view of Figure 1, has an extension along the second axis Y smaller than the extension of the respective implanted region 13.

The interfaces between the implanted regions 13 and the drift region 9 each form a PN diode 3.

The JBS diode 1 further comprises an anode metallization region 18, of metal material such as titanium, nickel, or molybdenum, which extends on the first surface 5A of the body 5, forming an anode A of the JBS diode 1.

Portions of the anode metallization region 18 in direct electrical contact with the drift region 9, alongside the implanted regions 13, form Schottky junctions (i.e. semiconductor-metal junctions), which each constitute a respective Schottky diode 2.

The Schottky junctions each have a respective barrier having, at equilibrium, a height Φ₀, which determines a switch-on threshold voltage of the respective Schottky diode 2.

In use, a bias voltage can be applied between the cathode K and the anode A of the JBS diode 1 so as to obtain a forward or reverse bias.

In detail, in forward bias (i.e. anode A at a higher potential than the cathode K), a forward voltage is applied in order to lower the barrier height Φ₀ of the Schottky junctions, so as to switch on the Schottky diodes 2 and enable the flow of an operating current, for example having a value of 10 A, between the anode A and the cathode K of the JBS diode 1.

A low barrier height Φ₀, and therefore a low switch-on threshold voltage of the Schottky diodes 2, enables to reduce the value of the forward voltage necessary for the flow of the operating current and therefore to obtain a reduced energy consumption of the JBS diode 1.

On the other hand, in reverse bias (i.e. cathode K at a higher potential than the anode A), the JBS diode 1 must guarantee a value of leakage current as low as possible between the anode A and the cathode K in the presence of high bias voltages, for example comprised between 600 V and 1300 V.

Such high bias voltages generate high electrical fields in the Schottky junctions, causing an increase of the leakage current, for example because of the tunnel effect. Such an increase is particularly significant especially if the barrier height Φ₀ is low.

Consequently, a low barrier height Φ₀ causes high leakage currents and therefore problems of operation of the JBS diode 1.

In reverse bias, each PN diode 3 causes formation of a respective depleted area, having a reduced concentration of charge carriers, which extends from the interface between the respective implanted region 13 and the drift region 9, mainly inside the drift region 9.

The depleted area contributes to lower locally, in the proximity of a respective Schottky junction, the value of electrical field generated by the high bias voltages.

It is thus known to design the JBS diode 1 so that the distance along the second axis Y between two adjacent implanted regions 13 is small, to the point where the depleted regions formed by two adjacent PN diodes 3 overlaps, thus lowering the electrical field of the entire Schottky junction and consequently lowering the leakage current.

However, such lowering of the electrical field is not sufficient, in specific applications, to guarantee that the JBS diode 1 complies with the technical specifications established at the design stage.

In fact, the electrical field in the drift region 9, in the proximity of the first surface 5A of the body 5 and between two adjacent implanted regions 13, has a profile, along the second axis Y, such that it assumes a minimum value close to the interface between the drift region 9 and an implanted region 13, grows by moving away from the implanted region 13 increases, and assumes a maximum value at a central point of the distance, along the second axis Y, between the two adjacent implanted regions 13. Therefore, the Schottky diodes 2 are subjected locally, in a central area between two adjacent implanted regions 13, to high electrical fields and therefore to high leakage currents.

Further reducing the distance between two adjacent implanted regions 13 can entail a further lowering of the electrical field in the central area between two adjacent implanted regions 13. However, this also leads to a smaller area of the Schottky diode 2 available for the flow of current in forward bias and therefore an increase in resistance of the JBS diode 1, with consequent deterioration of the performance of the JBS diode 1.

Documents WO 2018/005746 A1, JP 2015 162572 A and US 2015/061089 A1 disclose further examples of known vertical conduction electronic devices.

The aim of the present invention is to overcome the drawbacks of the prior art.

According to the present invention, a vertical conduction electronic device comprising a JBS diode and a manufacturing process thereof are provided, as defined in the annexed claims.

For a better understanding of the present invention, embodiments thereof are now described, purely by way of nonlimiting example, with reference to the attached drawings, wherein:
- Figure 1 shows a cross-sectional view of a known vertical conduction electronic device;
- Figure 2 shows a cross-section of an embodiment of the present vertical conduction electronic device, wherein electrical equivalents are highlighted;
- Figure 2A shows a detail of the cross-section of the electronic device of Figure 2, wherein geometrical parameters of the present electronic device are highlighted;
- Figure 3 shows a top plan view of the enlarged detail of the electronic device of Figure 2A;
- Figure 4 shows a plot of the evolution of the electrical field, in reverse bias, along the line A-A of Figure 2A;
- Figures 5A-5D are cross-sections of the electronic device of Figures 2, 2A and 3, in successive manufacturing steps;
- Figure 6 shows a top plan view of a different embodiment of the present vertical conduction electronic device;
- Figure 7 shows a top plan view of a different embodiment of the present vertical conduction electronic device;
- Figure 8 shows a top plan view of a further embodiment of the present vertical conduction electronic device;
- Figure 9 shows a cross section of the present vertical conduction electronic device, according to a different embodiment; and
- Figures 10A-10C shows cross-sections of the electronic device of Figure 9, in successive manufacturing steps.

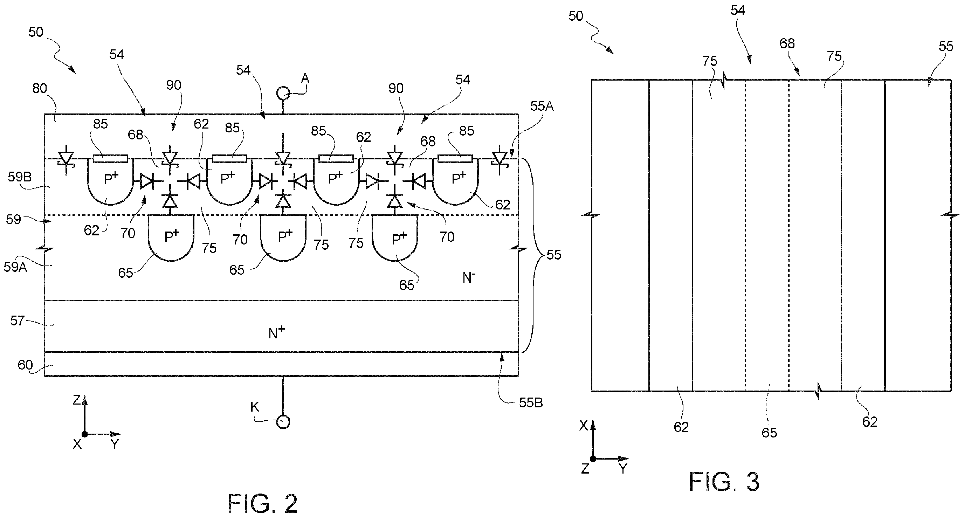

Figures 2, 2A, and 3 show a JBS (Junction Barrier Schottky) diode 50 in a Cartesian reference system XYZ having a first axis X, a second axis Y, and a third axis Z.

The JBS diode 50 is formed by a plurality of elementary cells 54, only some of which are shown in Figure 2, which are equal to one another and are connected in parallel in a same die.

The JBS diode 50 is formed in a body 55 of wide-bandgap semiconductor material, having a first surface 55A and a second surface 55B.

In particular, the body 55 is of silicon carbide, in one of its polytypes, here the 4H-SiC polytype.

In this embodiment, the body 55 comprises a substrate 57 and a drift region 59 overlying the substrate 57, for example grown epitaxially thereon.

The substrate 57 is of an N type, with a doping level such as to have low resistivity, for example comprised between 2 mΩ·cm and 30 mΩ·cm, has a thickness for example comprised between 50 µm and 360 µm, in particular 180 µm, and forms the second surface 55B of the body 55.

A cathode metallization region 60 of conductive material, for example nickel or nickel silicide, extends on the second surface 55B of the body 55 and forms a cathode K of the JBS diode 50.

The drift region 59 is of an N type, with a doping level lower than the doping level of the substrate 57, has a thickness, along the third axis Z, comprised between 5 µm and 15 µm, and forms the first surface 55A of the body 55.

In this embodiment, the drift region 59 comprises a first portion 59A and a second portion 59B, which are separated by a dashed line, for clarity, in Figures 2 and 2A.

The first portion 59A of the drift region 59 extends directly over the substrate 57 and has a doping level comprised between 1·10¹⁴ atoms/cm³ and 1·10¹⁶ atoms/cm³.

The second portion 59B of the drift region 59 extends on the first portion 59A, contiguous thereto, between the first portion 59A of the drift region 59 and the first surface 55A of the body 55, and has a thickness dₑ, comprised, for example, between 0.5 µm and 3 µm.

The second portion 59B of the drift region 59 has a higher doping level than the first portion 59A, for example comprised between 1·10¹⁵ atoms/cm³ and 1·10¹⁷ atoms/cm³.

The thickness of the first portion 59A, of the second portion 59B, and therefore of the drift region 59, can be chosen at the design stage according to the specific application of the JBS diode 50, for example according to a maximum operating voltage applicable to the JBS diode 50.

The JBS diode 50 further comprises a plurality of superficial implanted regions 62 and a plurality of deep implanted regions 65, all of a P type, accommodated in the drift region 59. In particular, the elementary cells 54 each comprise two superficial implanted regions 62 and one deep implanted region 65.

The superficial implanted regions 62 and the deep implanted regions 65 each form, at the interface with the drift region 59, a respective PN diode 70.

The superficial implanted regions 62 each extend from the first surface 55A of the body 55 within the drift region 59. In particular, here, the superficial implanted regions 62 each extend in the second portion 59B of the drift region for a depth, along the third axis Z, smaller than the thickness dₑ of the second portion 59B.

The superficial implanted regions 62 each have a width, along the second axis Y, comprised, for example, between 1 µm and 5 µm, and are mutually arranged at a distance S_{Y}, along the second axis Y, for example comprised between 1 µm and 5 µm.

Two adjacent superficial implanted regions 62 delimit a contact portion 68 of the drift region 59, in particular, here, of the second portion 59B of the drift region 59.

The superficial implanted regions 62 each have a high doping level, for example higher than 1·10¹⁸ atoms/cm³.

The deep implanted regions 65 each extend at a distance from the first surface 55A of the body 55.

In detail, the deep implanted regions 65 extend in the first portion 59A of the drift region 59.

In particular, here, the deep implanted regions 65 extend from the interface between the first and the second portions 59A, 59B of the drift region 59.

The deep implanted regions 65 may each have a width, along the second axis Y, that is approximately equal to or different from that of the superficial implanted regions 62, comprised for example between 1 µm and 5 µm.

The deep implanted regions 65 are arranged staggered with respect to the superficial implanted regions 62; in particular, each deep implanted region 65 is arranged, along the second axis Y, between two adjacent superficial implanted regions 62.

The deep implanted regions 65 each have a high doping level, for example higher than 1·10¹⁸ atoms/cm³.

In particular, the doping level of the deep implanted regions 65 may be lower than or equal to the doping level of the superficial implanted regions 62. For instance, a lower doping level of the deep implanted regions 65 may overall entail a lower resistivity of the body 55, since the deep implanted regions 65 have an opposite type of doping with respect to the drift region 59, and therefore entail a lower electrical resistance of the JBS diode 50.

The superficial implanted regions 62 each delimit, together with a respective deep implanted region 65, a respective passage section 75 of the drift region 59. The dimensions of the passage section 75 depend upon the relative position between the superficial implanted region 62 and the respective deep implanted region 65 by which it is delimited. In particular, the area of the passage sections 75 may be determined, at the design stage, by choosing (Figure 2A) the thickness dₑ, the distance S_{Y}, and the width, along the second axis Y, of the deep implanted regions 65.

As shown in Figure 3 for an elementary cell 54, in a top view of the body 55, the superficial implanted regions 62 and the deep implanted regions 65 (the latter being indicated by dashed lines) each extend strip-shaped along the first axis X.

The JBS diode 50 further comprises an anode metallization region 80, of metal material such as titanium, nickel, or molybdenum, which extends over the first surface 55A of the body 55, forming an anode A of the JBS diode 50.

The anode metallization region 80 is in direct electrical contact with the superficial implanted regions 62 and with the contact portions 68 of the drift region 59.

In detail, the anode metallization region 80 is in ohmic contact with the superficial implanted regions 62.

In order to lower the contact resistance between the anode metallization region 80 and the superficial implanted regions 62, the JBS diode 50 also comprises a plurality of ohmic-contact regions 85, of conductive material, for example nickel silicide, one for each superficial implanted region 62. The ohmic-contact regions 85 each extend on the first surface 55A of the body 55 and partially within the respective superficial implanted region 62, and have a width, along the second axis Y, smaller than or equal to, here smaller than, the respective superficial implanted region 62.

The contact portions 68 of the drift region 59 each form a Schottky junction with the anode metallization region 80, forming a respective Schottky diode 90.

The Schottky junctions each have a respective barrier having, at equilibrium, a height Φ₀, which determines a switch-on threshold voltage of the respective Schottky diode 90.

In this embodiment, the deep implanted regions 65 are floating.

In use, in reverse bias, a reverse voltage is applied between the anode A and the cathode K of the JBS diode 50 and maintains the Schottky diodes 90 and the PN diodes 70 in an off state. Therefore, as a whole, also the JBS diode 50 is in an off state.

In reverse bias, in particular in power applications, the reverse voltage can assume high values, for example comprised between 600 V and 1300 V.

The reverse voltage causes the interfaces between the superficial implanted regions 62 and the drift region 59 to form each a respective depleted region, having a reduced concentration of charge carriers. Each depleted region generates an electrical field, whose field lines locally reduce the electrical field generated by the reverse voltage, in the respective contact portion 68 of the drift region 59, in particular in the proximity of the respective PN junction.

The reverse voltage also causes formation of a depleted region at the interface between the drift region 59 and each deep implanted region 65. In particular, said depleted region extends in a central portion between two adjacent superficial implanted regions 62, within a respective contact portion 68 of the drift region 59. Said depleted regions therefore reduce further the value of the electrical field in the contact portions 68 of the drift region 59, in particular in the respective central portions.

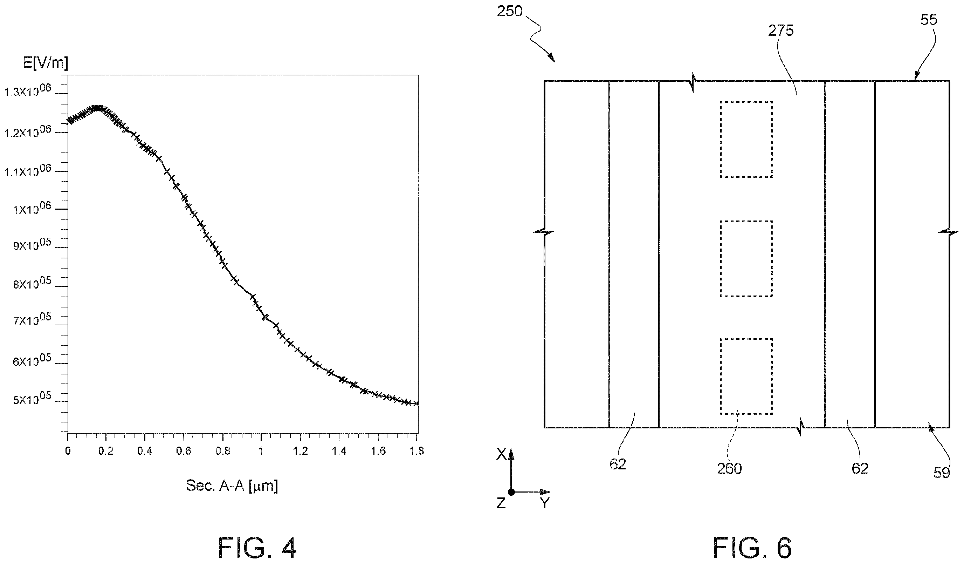

The above electrical behaviour is shown in the simulation of Figure 4 performed by the Applicant, which represents the trend of the electrical field E along the line A-A of Figure 2A, taken parallel to the second axis Y, in the proximity of the first surface 55A of the body 55. In detail, the line A-A extends from the interface between a superficial implanted region 62 and a contact portion 68 of the drift region 59, to a central point of the contact portion 68 of the drift region 59.

Thus, it follows that the electrical field of the contact portions 68 of the drift region 59, in the proximity of the first surface 55A of the body 55, has a low average value.

The Schottky diodes 90 are therefore each subjected, in the proximity of the respective Schottky junctions, to a low average electrical field; thus, the Schottky diodes 90 each develop low leakage currents, even in the presence of a high reverse voltage between the anode A and the cathode K.

Consequently, as a whole, the JBS diode 50 is able to achieve low leakage currents in reverse bias.

In forward bias, a forward voltage higher than the switch-on threshold voltage of the JBS diode 50 is applied between the cathode K and the anode A so as to bring the JBS diode 50 into an on state and enable the flow of an operating current between the anode A and the cathode K. The JBS diode 50 enables the flow of a high value of the operating current, for example 10 A, even when the forward voltage is low.

The value of the operating current at a forward voltage depends in fact, for example, upon the height of the barrier Φ₀ of the Schottky diodes 90 and upon the resistance of the conductive path between the anode A and the cathode K. The JBS diode 50 has a low resistance of the conductive path between the anode A and the cathode K.

At the design stage, it is possible to tune the characteristics of the JBS diode 50 by varying the distance Sy between two adjacent superficial implanted regions 62. For instance, the distance S_{Y} can be increased so as to increase the area of the contact portions 68 available for the flow of current in forward bias.

Moreover, at the design stage, it is also possible to tune the characteristics of the JBS diode 50 by maintaining the distance S_{Y} constant and varying the area of the passage sections 75 of the drift region 59, as described above. For instance, if it is preferable to achieve a lower value of the leakage current, it is possible to reduce the thickness dₑ that determines the depth from the first surface 55A of the deep implanted regions 65, and/or increase the width, along the second axis Y, of the deep implanted regions 65. In this way, the respective depleted areas approach the first surface 55A of the body 55 and extend, along the second axis Y, for a larger portion of the distance S_{Y} between two adjacent superficial implanted regions 62.

Described hereinafter are steps for manufacturing the JBS diode 50, in particular the manufacturing steps that lead to form the superficial implanted regions 62 and the deep implanted regions 65.

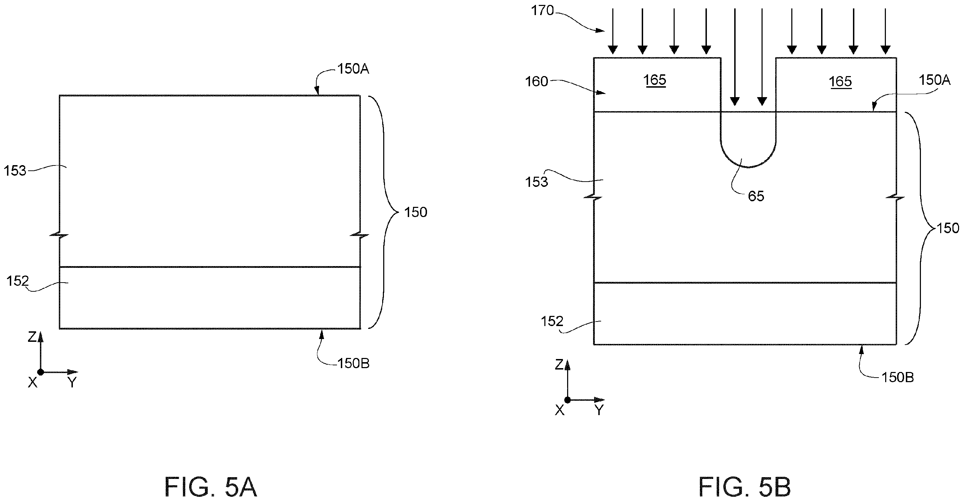

Figure 5A shows a wafer 150 of silicon carbide, having a doping of an N type, a first surface 150A and a second surface 150B. The wafer 150 comprises a work substrate 152, which is intended to form the substrate 57, and a drift layer 153, which is intended to form the first portion 59A of the drift region 59. The drift layer 153, for example, has been grown epitaxially on the work substrate 152.

The drift layer 153 forms the first surface 150A of the wafer 150, and the work substrate 152 forms the second surface 150B of the wafer 150.

Next (Figure 5B), a first mask 160 is formed on the first surface 150A of the wafer 150, for example through known lithographic steps. The first mask 160 comprises a plurality of portions 165, mutually spaced apart so as to expose portions of the wafer 150 where the deep implanted regions 65 are intended to be formed. Using the first mask 160, a first implantation of dopant ions of a P type (here indicated by first arrows 170), for example boron or aluminium ions, is performed.

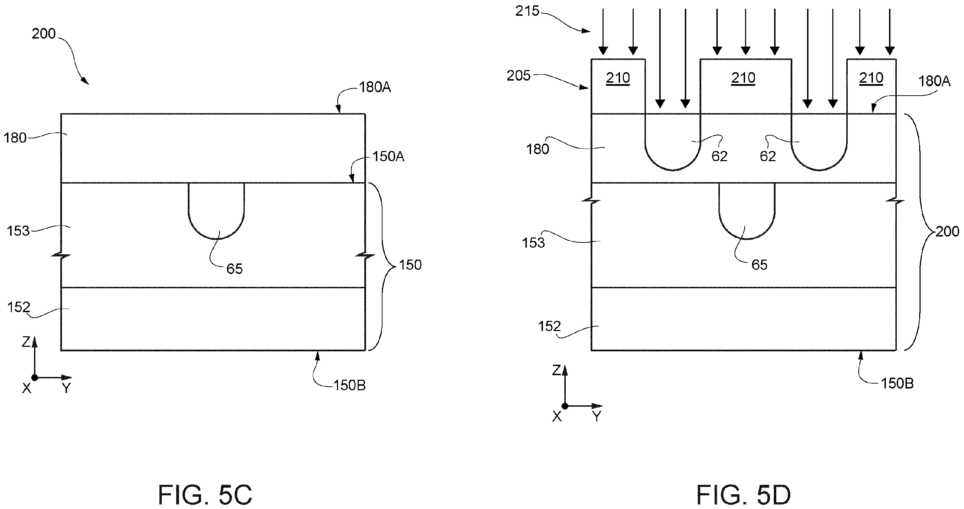

Next (Figure 5C), the first mask 160 is removed, and an epitaxial layer 180 is grown on the first surface 150A of the wafer 150. The epitaxial layer 180 is delimited by a surface 180A and may have a uniform doping level, along the third axis Z, or a variable doping level, and may be equal to or different from the doping level of the drift layer 153.

Here, the epitaxial layer 180, which corresponds to the second portion 59B of the drift region 59, has a higher doping level than the drift layer 153, which, as mentioned above, is intended to form the first portion 59A.

The wafer 150 and the epitaxial layer 180 form a work wafer 200 (which is intended to form the body 55), which has a first surface corresponding to the surface of the epitaxial layer 180A, and therefore still indicated by 180A, and a second surface, corresponding to the second surface 150B of the wafer 150, and therefore still indicated by 150B.

In Figure 5D, a second mask 205 is formed on the first surface 180A of the work wafer 200, for example through known lithographic steps.

The second mask 205 comprises a plurality of portions 210, mutually spaced apart so as to expose portions of the work wafer 200 where the superficial implanted regions 62 are intended to be formed.

Using the second mask 205, a second implantation of dopant ions of a P type (here indicated by second arrows 215), for example aluminium or boron ions, is performed.

The second implantation forms the superficial implanted regions 62.

Next, the second mask 205 is removed, and the work wafer 200 undergoes annealing, for example at a temperature higher than 1600°C, to activate the dopant ions of the superficial implanted regions 62 and of the deep implanted regions 65.

The ohmic-contact regions 85 and the anode metallization region 80 are then formed, in a known way.

Moreover, known manufacturing steps follow, such as thinning of the work substrate 152, formation of the cathode metallization region, dicing of the work wafer 200 and packaging, to obtain the JBS diode 50.

Figure 6 shows a different embodiment of the present JBS diode, here designated by 250. The JBS diode 250, here shown only in top plan view, has a general structure similar to that of the JBS diode 50 of Figures 2, 2A, and 3. Consequently, elements in common are designated by the same reference numbers and are not further described.

In detail, the JBS diode 250 is formed in the body 55, which comprises the substrate 57, here not visible, and the drift region 59, which accommodates the superficial implanted regions 62. Furthermore, the JBS diode 250 comprises the anode metallization region 80, the cathode metallization region 60, and the ohmic-contact regions 85, which are not visible in Figure 6.

The deep implanted regions, here designated by 260 and represented by dashed lines, are arranged deep in the drift region 59, at a distance from the first surface 55A of the body 55, in a way similar to what has been discussed with reference to the deep implanted regions 65 of the JBS diode 50.

In this embodiment, each deep implanted region 260 forms a respective plurality of pockets, mutually spaced apart along the first axis X. Consequently, the passage sections of the drift region 59, here designated by 275, also extend between two adjacent deep implanted regions 260.

It is thus possible to design the distance, along the first axis X, between two adjacent deep implanted regions 260 so as to tune the area of the drift region 59 available for the flow of the operating current, in use, in forward bias. The JBS diode 250 therefore is highly versatile in adapting to the technical specifications required by different applications.

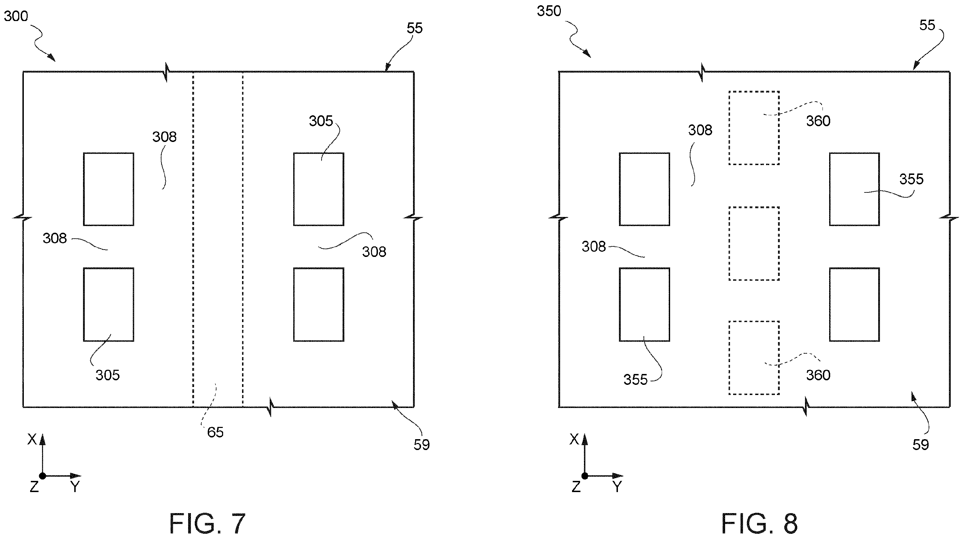

Figure 7 shows a different embodiment of the present JBS diode, here designated by 300. The JBS diode 300, here shown only in top plan view, has a general structure similar to that of the JBS diodes 50, 250. Consequently, elements in common are designated by the same reference numbers and are not further described .

In detail, also the JBS diode 300 is formed in the body 55, and the drift region 59 accommodates a plurality of superficial implanted regions, here designated by 305, and the deep implanted regions 65, the latter being represented by a dashed line.

The deep implanted regions 65 also here extend each, strip-shaped, along the first axis X.

In this embodiment, each superficial implanted region 305 forms a respective plurality of pockets, mutually spaced apart along the first axis X.

Therefore, in the JBS diode 300, the contact portions of the drift region, here designated by 308, extend both between two adjacent superficial implanted regions 305 along the second axis Y and between two adjacent superficial implanted regions 305 along the first axis X. Consequently, the contact portions 308 of the drift region 59, which are in Schottky contact with the anode metallization region 80 (here not shown), have a large area. Therefore, the conductive path between the anode A and the cathode K of the JBS diode 300, in forward bias, has a low resistance. Thus, the JBS diode 300 has a low energy consumption.

Figure 8 shows a further embodiment of the present JBS diode, here designated by 350. The JBS diode 350, here shown only in top plan view, has a general structure similar to the combination of the JBS diodes 250, 300. Consequently, elements in common are designated by the same reference numbers and are not further described.

In detail, in the JBS diode 350, both the superficial implanted regions, here designated by 355, and the deep implanted regions, here designated by 360 and represented by dashed lines, form pockets that are mutually spaced apart along the first axis X.

Furthermore, in this embodiment, the superficial implanted regions 355 and the deep implanted regions 360 are arranged mutually staggered also along the first axis X; i.e., along the second axis Y, a superficial implanted region 355 is non-aligned with respect to a respective deep implanted region 360. In other words, considering a plurality of section lines that are parallel to the second axis Y and have different coordinates on the first axis X, for some of these section lines, no deep implanted region 360 is visible between two superficial implanted regions 355 that are adjacent along the second axis Y.

In the JBS diode 350, it is thus possible to design the area available for the flow of current, in forward bias, by varying both the distance along the first axis X between two adjacent deep implanted regions 360 and the distance along the first axis X between two adjacent superficial implanted regions 355. The JBS diode 350 therefore is highly versatile in adapting to the technical specifications required in different applications.

It will be clear to the person skilled in the art that the JBS diodes 250, 300, 350 can be obtained, from the wafer 150 of Figure 5A, through manufacturing steps that are similar to the ones already described with reference to Figures 5A-5D for the JBS diode 50 and therefore not further described.

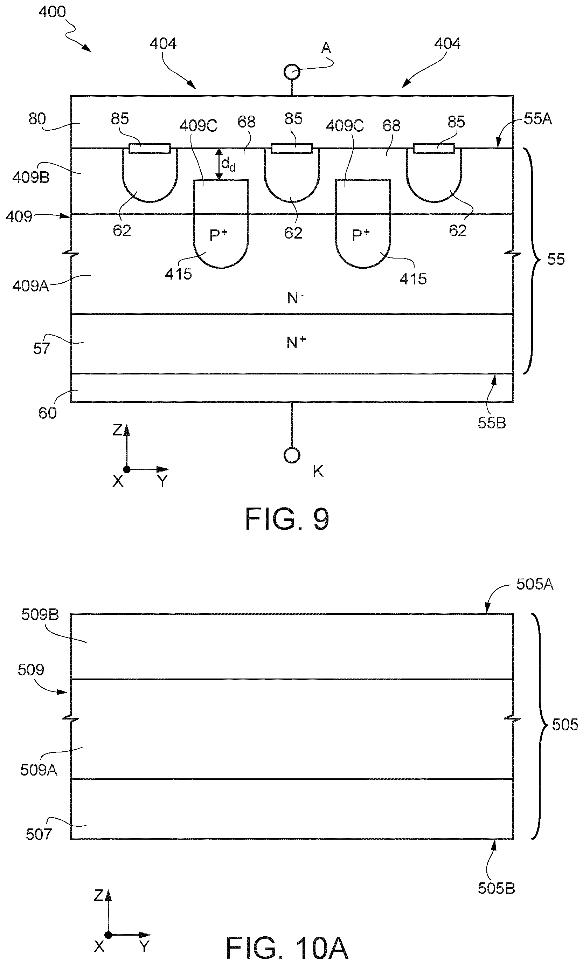

Figure 9 shows a different embodiment of the present JBS diode, here indicated by 400. The JBS diode 400 has a general structure similar to that of the JBS diode 50 of Figures 2, 2A, and 3. Therefore, elements in common are designated by the same reference numbers and are not further described.

In detail, the JBS diode 400 is formed by a plurality of elementary cells 404, of which only two elementary cells 404 are shown in Figure 9, which are equal to one another and are connected in parallel in a same die.

The JBS diode 400 is formed in the body 55 comprising the substrate 57 and the drift region, here indicated by 409.

The JBS diode 400 comprises the superficial implanted regions 62, extending in the drift region 409 from the first surface 55A of the body 55, and deep implanted regions 415, extending in the drift region 409 at a distance from the first surface 55A of the body 55.

In detail, each elementary cell 404 comprises two superficial implanted regions 62 and one deep implanted region 415.

The deep implanted regions 415, also here of P type, are arranged staggered with respect to the superficial implanted regions 62; in particular, each deep implanted region 415 is arranged, along the second axis Y, between two adjacent superficial implanted regions 62.

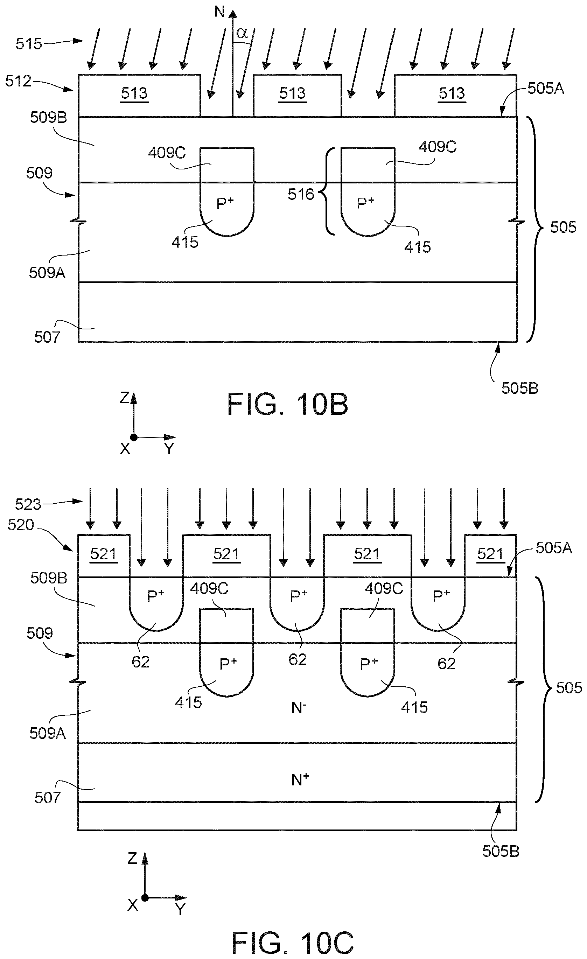

In this embodiment, the deep implanted regions 415 are channelling-implanted regions, as discussed hereinafter with respect to Figure 10B.

The drift region 409, of N type, comprises a first portion 409A, extending on the substrate 57, and a second portion 409B, extending on the first portion 409A and forming the first surface 55A of the body 55.

The second portion 409B has a higher doping level than the first portion 409A. For example, the first portion 409A has a doping level comprised between 1·10¹⁴ atoms/cm³ and 1·10¹⁶ atoms/cm³ and the second portion 409B has a doping level comprised between 1·10¹⁵ atoms/cm³ and 1·10¹⁷ atoms/cm³.

Moreover, in this embodiment, for each elementary cell 404, the drift region 409 further comprises a third portion 409C arranged within the second portion 409B, above the respective deep implanted region 415.

The third portion 409C is arranged, along a direction parallel to the third axis Z, between the respective deep implanted region 415 and the first surface 55A of the body 55.

In detail, the third portion 409C extends at a distance d_{d}, for example comprised between 0.3 µm and 1.5 µm, from the first surface 55A of the body 55.

In practice, the third portion 409C of the drift region 409 is aligned to the respective deep implanted region 415, along a direction parallel to the third axis Z.

The third portion 409C of the drift region 409, of N type, has a lower doping level than the second portion 409B.

In Figure 9, the third portion 409C has, for simplicity, a rectangular shape; however, the third portion 409C may have a different shape, regular or non regular, depending on the specific implantation step that is used to form the deep implanted region 415 and the doping profile of the second portion 409B of the drift region 409.

Moreover, in Figure 9, the third portion 409C extends in direct contact with the deep implanted region 415; however, the third portion 409C may not be in direct contact with the deep implanted region 415, depending on the doping level of the second portion 409B, the doping level of the deep implanted region 415 and the specific implantation step that is used to form the deep implanted region 415.

The JBS diode 400 further comprises the anode metallization region 80, the cathode metallization region 60, and the ohmic-contact regions 85.

The presence of the deep implanted regions 415 allows to improve, in use, the electrical performances of the JBS diode 400, similarly to what explained hereinabove for the JBS diode 50 of figure 2.

Moreover, the fact that the deep implanted regions 415 are formed through a channelling implantation step allows to reduce the manufacturing costs of the JBS diode 400, as discussed hereinafter with respect to Figures 10A-10C.

Described hereinafter are steps for manufacturing the JBS diode 400, in particular the manufacturing steps that lead to form the superficial implanted regions 62 and the deep implanted regions 415.

Figure 10A shows a work wafer 505 of silicon carbide, having a doping of an N type, a first surface 505A and a second surface 505B. The work wafer 505 comprises a work substrate 507, which is intended to form the substrate 57, and a work drift region 509, which is intended to form the drift region 409. The work drift region 509 comprises a first layer 509A, intended to form the first portion 409A of the drift region 409, and a second layer 509B, intended to form the second portion 409B of the drift region 409.

The first layer 509A and the second layer 509B of the work drift region 509 have been grown, for example, epitaxially on the work substrate 507.

The work drift region 509 forms the first surface 505A of the work wafer 505, and the work substrate 507 forms the second surface 505B of the work wafer 505.

In detail, the work wafer 505 is of crystalline SiC in one of its polytypes, for example 3C-SiC, 4H-SiC and 6H-SiC, here 4H-SiC. The first surface 505A of the work wafer 505 is tilted by a cut angle with respect to one of the crystalline planes of the work wafer 505.

In this embodiment, the first surface 505A of the work wafer 505 is tilted by the cut angle with respect to the C-plane of the 4H-SiC, i.e. with respect to the face (000-1) of the 4H-SiC, wherein the values 0, 0, 0, -1 are, respectively, the Bravais-Miller indexes h, k, i, 1.

For example, the first surface 505A may be parallel to the C-plane, i.e. having a zero cut angle with respect to the C-plane, or tilted by an angle comprised between 3.5° and 4.5°, in particular equal to 4°, with respect to the C-plane.

Next, Figure 10B, a first mask 512 is formed on the first surface 505A of the work wafer 505, for example through known lithographic steps. The first mask 512 comprises a plurality of portions 513, mutually spaced apart so as to expose portions of the work wafer 505 where the deep implanted regions 415 are intended to be formed. Using the first mask 512, a first implantation of dopant ions of a P type (here indicated by arrows 515), for example boron or aluminium ions, is performed.

The first implantation is performed through a channelling implantation step, for example with an implantation energy comprised between 200 keV and 800 keV.

In detail, in the channelling implantation step, the dopant ions 515 are implanted at an angle α with respect to a direction N perpendicular to the first surface 505A of the work wafer 505. The angle α depends on the cut angle of the first surface 505A of the work wafer 505. For example, if the first surface 505A is parallel to the C-plane of the crystalline 4H-SiC, then the angle α may be comprised between -1° and 1°, in particular equal to 0°.

For example, if the cut angle of the first surface 505A is 4° with respect to the C-plane of the crystalline 4H-SiC, then the angle α may be comprised between 3.5° and 4.5°, in particular equal to 4°; this allows to intercept the [0001] channelling direction in the work wafer 505.

However, the angle α may have different values, for example 17° or 21°, in order to intercept other channelling directions in the work wafer 505, such as direction [11-23], which is titled by about 17° away from direction [0001].

The channelling implantation step exploits the crystalline symmetry of the work wafer 505, in order to implant the dopant ions 515 along directions having a lower scattering probability with the silicon and carbon atoms of the work wafer 505.

In detail, the channelling implantation step may be performed using a single implantation step.

The channelling implantation causes the dopant ions 515 to be implanted over a region 516 having a depth, parallel to the third axis Z, for example comprised between 0.5 µm and 2.5 µm, that is greater than the depth that may be obtained with conventional implantation steps having the same implantation energy as the channelling implantation.

The channelling implantation is performed so that a first part of the dopant ions 515 are implanted within the first drift layer 509A and a second part of the dopant ions 515 are implanted within the second drift layer 509B.

In detail, the dose of the dopant ions 515 is chosen so that the first part of the dopant ions 515 implanted in the first drift layer 509A inverts the conductivity type of the first drift layer 50ùA, thereby forming the deep implanted regions 415, and the second part of the dopant ions 515 implanted in the second drift layer 509B lowers the doping level of the second drift layer 509B, without inverting the conductivity type of the second drift layer 509B, thereby forming the third portions 409C of the drift region 409.

The first mask 512 is then removed.

Subsequently, Figure 10C, a second mask 520 is formed on the first surface 505A of the work wafer 505, for example through known lithographic steps.

The second mask 520 comprises a plurality of portions 521, mutually spaced apart so as to expose portions of the work wafer 505 where the superficial implanted regions 62 are intended to be formed.

Using the second mask 520, a second implantation of dopant ions of a P type (here indicated by arrows 523), for example aluminium or boron ions, is performed.

The second implantation forms the superficial implanted regions 62.

Next, the second mask 520 is removed and the work wafer 505 undergoes annealing, for example at a temperature higher than 1600°C, to activate the dopant ions of the superficial implanted regions 62 and of the deep implanted regions 415.

The ohmic-contact regions 85 and the anode metallization region 80 are then formed, in a known way.

Moreover, known manufacturing steps follow, such as thinning of the work substrate 507, formation of the cathode metallization region, dicing of the work wafer 505 and packaging, to obtain the JBS diode 400.The channelling implantation step of figure 10B allows the deep implanted regions 415 to have a low lateral straggling, for example parallel to the second axis Y, for example of about 10 nm if the dopant ions 515 are implanted with an implantation energy of 400 keV. The reduced straggling allows to decrease the process variability associated with the formation of the deep implanted regions 415. Therefore, it is possible to design the JBS diode with a higher density of the elementary cells 404.

Moreover, the channelling implantation step allows to implant the dopant ions 515 deep in the work drift region 509 by using a low implantation energy, for example 400 keV, thereby forming a small amount of defects in the work drift region 509.

By using the channelling implantation step, the growth of both the first and the second drift layers 509A, 509B may be performed in a single epitaxy step, before forming the deep implanted regions 415 and the superficial implanted regions 62. Growing the first and the second drift layers 509A, 509B in a single epitaxy step allows to reduce the manufacturing costs and to simplify the manufacturing process of the present JBS diode. In detail, both the first mask 512 and the second mask 520 are formed on the first surface 505A of the work wafer 505. Therefore, it is possible to obtain a better alignment between the second mask 520 and the first mask 512.

In addition, performing a channelling implantation allows to avoid using high energy implantation, for example of few MeV, which requires expensive dedicated equipment, in order to obtain the deep implanted regions 415.

Finally, it is clear that modifications and variations may be made to the vertical conduction electronic device and to the corresponding manufacturing process described and illustrated herein, without thereby departing from the scope of the present invention, as defined in the annexed claims.

For instance, the conductivity types, P and N, may be reversed and what has been described above may also be applied to an MPS (Merged PiN Schottky) diode.

In addition, the superficial implanted regions and the deep implanted regions may have, in top view, any shape, for example, they may form regular or irregular geometrical figures, such as hexagons or circles. Alternatively, the superficial implanted regions and the deep implanted regions may be portions of a single region of a more complex shape, for example, they may form a ring.

The deep implanted regions may be in direct electrical contact with the anode metallization region, by electrical connection regions, which are represented schematically in Figure 2A by the dashed line 99. For instance, in the case where the deep implanted regions are strip-shaped, the deep implanted regions can be in direct electrical contact with the anode metallization region at the edges of the vertical conduction electronic device, for example through a trench formed in the body from the first surface of the body.

For example, when the deep implanted regions are formed through a channelling implantation step, the third portions 409C of the drift region 409 may be absent, depending on the specific doping profile of the drift region 409 and of the deep implanted regions 415. In practice, all the dopant ions 515 of the channelling implantation step of figure 10B may contribute to the formation of the deep implanted regions 415.

The embodiments shown and described hereinabove may be combined to provide further solutions.

## Claims

1. A vertical conduction electronic device (50; 250; 300; 350; 400) comprising:
a body (55) of wide-bandgap semiconductor material having a first conductivity type and a surface (55A) defining a first direction (Y) and a second direction (X), the body including a drift region (59, 59A, 59B; 409);
a plurality of superficial implanted regions (62; 305; 355) having a second conductivity type, extending in the drift region, from the surface, the superficial implanted regions delimiting between them, in the drift region, at least one superficial portion (68; 308) facing the surface;
at least one deep implanted region (65; 260; 360; 415) having the second conductivity type, extending in the drift region, at a distance from the surface of the body; and
a metal region (80) extending on the surface of the body, in Schottky contact with the superficial portion (68) of the drift region.

2. The electronic device according to the preceding claim, wherein two superficial implanted regions (62; 305; 355) of the plurality of superficial implanted regions are arranged at a mutual distance along the first direction (Y), and the deep implanted region (65; 260; 360; 415) extends, along the first direction, between the two superficial implanted regions (62; 305; 355) of the plurality of superficial implanted regions.

3. The electronic device according to claim 1 or 2, wherein the drift region comprises a first portion (59A; 409A) and a second portion (59B; 409B), overlying one another, the first portion having a first doping level and the second portion having a second doping level higher than the first doping level, the second portion extending between the first portion and the surface (55A) of the body.

4. The electronic device according to the preceding claim, wherein the drift region (409) further comprises a third portion (409C) having a lower doping level than the second portion (409B), the third portion of the drift region extending at a distance (d_{d}) from the surface (55A) of the body, between the deep implanted region (415) and the surface of the body.

5. The electronic device according to claim 3 or 4, wherein the deep implanted region (65; 260; 360; 415) extends in the first portion (59A; 409A) of the drift region (59), and the superficial implanted regions (62; 305; 355) extend in the second portion (59B; 409B) of the drift region.

6. The electronic device according to any one of the preceding claims, wherein the superficial implanted regions (62; 305; 355) are in ohmic contact with the metal region (80) .

7. The electronic device according to any one of the preceding claims, wherein the deep implanted region (65; 260; 360; 415) is floating.

8. The electronic device according to any one of the claims 1-6, wherein the deep implanted region is in direct electrical contact (99) with the metal region.

9. The electronic device according to any one of the preceding claims, wherein the superficial implanted regions (62; 305; 355) have a superficial doping level and the deep implanted region has a deep doping level, the superficial doping level being higher than the deep doping level.

10. The electronic device according to any one of the preceding claims, wherein the deep implanted region (260; 360) comprises a plurality of deep implanted portions, which are arranged at a mutual distance from each other and aligned along the second direction (X), and are arranged, along the first direction, between two adjacent superficial implanted regions (62; 355) of the plurality of superficial implanted regions.

11. The electronic device according to any one of the preceding claims, wherein the plurality of superficial implanted regions (305; 355) comprises a first and a second row of superficial implanted regions, the first row of superficial implanted regions comprising a first plurality of superficial implanted portions arranged at a mutual distance from each other and aligned along the second direction (X), and the second row of superficial implanted regions comprising a second plurality of superficial implanted portions arranged at a mutual distance from each other and aligned along the second direction.

12. The electronic device according to any one of claims 1-10, wherein the superficial implanted regions (62) and the deep implanted region (65) extend, strip-shaped, in the second direction.

13. The electronic device according to any of the preceding claims, wherein the deep implanted regions (415) are channelling-implanted regions.

14. A process for manufacturing a vertical conduction electronic device, from a work wafer (200; 505) of wide-bandgap semiconductor material having a first conductivity type and a surface (180A; 505A), the work wafer including a drift region (59, 153, 180; 509), the process comprising:
forming, in the drift region, a plurality of superficial implanted regions (62; 305; 355) having a second conductivity type, extending from the surface, the superficial implanted regions delimiting between them, in the drift region, at least one superficial portion (68; 308) facing the surface;
forming, in the drift region, at least one deep implanted region (65; 260; 360; 415) having the second conductivity type, at a distance from the surface of the body; and
forming a metal region (80) on the surface of the body, the metal region being in Schottky contact with the superficial portion of the drift region.

15. The manufacturing process according to the preceding claim, wherein forming the at least one deep implanted region comprises, starting from a work body (150) having the first conductivity type, a surface (150A) and a drift layer (153) delimited by the surface of the work body, implanting first dopant ions (170) on the surface of the work body using a first mask (160).

16. The manufacturing process according to the preceding claim, wherein forming the plurality of superficial implanted regions comprises:
growing an epitaxial layer (180) on the surface of the work body, forming the work wafer; and
implanting second dopant ions (215), on the surface of the work wafer, using a second mask (205).

17. The manufacturing process according to claim 14, wherein forming the deep implanted region (415) comprises implanting first dopant ions (515) on the surface (505A) of the work wafer (505) using a first mask (512), the first dopant ions being implanted along directions tilted by an angle (α) with respect to a direction perpendicular to the surface (505A) of the work wafer (505), the angle being a function of the crystallographic orientation of the surface (505A) of the work wafer (505), so that the dopant ions (515) undergoes a channelling effect in the work wafer.

18. The manufacturing process according to the preceding claim, wherein forming the superficial implanted regions comprise implanting second dopant ions (523) on the surface (505A) of the work wafer (505), using a second mask (520).
